# EUROPEAN PATENT APPLICATION

(11) **EP 4 318 449 A1**
(43) Date of publication of application: **07.02.2024**
(21) Application number: 22778469.1
(22) Date of filing: 04.03.2022
(51) Int. Cl.: G09G 3/32, G09G 3/00

(54) **LED DISPLAY SCREEN AND DATA DISPLAY CONTROL METHOD THEREFOR, AND SCREEN SYSTEM**

(30) Priority: 01.04.2021 CN 202110360058
(71) Applicant: Shenzhen Time Waying Technology Co., Ltd., Shenzhen, Guangdong 518000 (CN)
(72) Inventor: ZHU, Qiang, Shenzhen, Guangdong 518000 (CN); CHOW, Wingyip Kenny, Shenzhen, Guangdong 518000 (CN)
(74) Representative: Zaboliene, Reda
(86) International application number: PCT/CN2022/079333
(87) International publication number: WO 2022/206285

(57) **Abstract**

Disclosed in the present application are an LED display screen and a data display control method therefor, and a screen system. The display screen includes a plurality of LED boxes, and each of the LED boxes includes a plurality of LED modules capable of emitting triggering signals. The data display control method for display screen includes: acquiring the triggering signals emitted by the LED modules of any LED box; determining whether the triggering signals of the LED modules of any LED box body are tampering signals; and controlling the LED boxes to stop displaying data when all of the triggering signals emitted by the LED modules of any LED box body are tampering signals. By means of the technical solution of the present application, it is possible to detect whether the LED modules work normally, thereby improving the accuracy and security of data display performed by the LED modules.

## Description

### CROSS-REFERENCE TO RELATED APPLICATIONS

This application claims the priority of Chinese patent application No. 202110360058.7, entitled "LED DISPLAY SCREEN AND DATA DISPLAY CONTROL METHOD THEREFOR, AND SCREEN SYSTEM" and submitted to the State Intellectual Property Office of P.R.C. on Apr. 1, 2021, the entire contents of which are hereby incorporated by reference.

### TECHNICAL FIELD

This application relates to the technical field of display screens, in particular to an LED display screen and a data display control method therefor, and a screen system.

### BACKGROUND

With the continuous development of display technology, LED display screens have been widely used in various display screens that display text, images, videos, and other data. LED display screens are generally divided into pre maintenance display screens and post maintenance display screens according to maintenance manners. For a pre maintenance display screen, it includes a plurality of LED modules and a printed circuit board assembly (PCBA) connected to the LED modules. When the pre maintenance display screen is used to display various types of information, due to the need for replacement or maintenance, the LED modules at this time are in an abnormal state, which is prone to the problem of the LED module's playing information being hijacked or tampered with. For this reason, the pre maintenance display screen typically includes a display data protection circuit for protecting the copyright of playback information. In practical applications, the above-mentioned LED modules are prone to abnormal display issues during replacement or maintenance, which affects the display of the pre maintenance display screen.

In view of this, it is necessary to propose further improvements to the current display method of the display screen.

### SUMMARY OF THE INVENTION

### TECHNICAL PROBLEM

Enter a description for the technical problem here.

### SOLUTION TO THE PROBLEM

### TECHNICAL SOLUTION

According to embodiments of the present application, an LED display screen and a data display control method therefor, and a screen system are provided.

A data display control method for display screen, wherein the display screen includes a plurality of LED boxes, and each of the plurality of LED boxes includes a plurality of LED modules capable of emitting triggering signals, includes:
acquiring the triggering signals emitted by the LED modules of any LED box;
determining whether the triggering signals of the LED modules of any LED box are tampering signals;
controlling the LED boxes to stop displaying data when all of the triggering signals emitted by the LED modules of any LED box are tampering signals.

Wherein, the LED box further includes a PCBA being electrically connected to the plurality of LED modules, respectively, and
the step of determining whether all of the triggering signals of the LED modules of any LED box are tampering signals includes:
determining an interface status between any LED module and the PCBA;
generating a triggering signal and determining that this triggering signal is tampering signal when all of the interface statuses between any LED module and the PCBA are disconnected;
generating a triggering signal and determining that this triggering signal is non-tampering signal when the interface status between any LED module and the PCBA is connected.

Wherein, the PCBA includes an anti-tamper circuit, and
after the step of determining the interface status between any LED module and the PCBA, the method includes:
generating a triggering signal and determining that this triggering signal is tampering signal when all of the interface statuses between any LED module and the PCBA are high level;
generating a triggering signal and determining that this triggering signal is non-tampering signal when the interface status between any LED module and the PCBA is low level, and controlling the LED boxes to continue to display data based on the non-tampering signal.

An LED display screen includes a plurality of LED boxes, and each of the LED boxes includes a plurality of LED modules capable of emitting triggering signals and a data display control device for executing the foregoing method.

Wherein, the LED box further includes a box shell being provided with an accommodating space and a PCBA, a protection panel and a plurality of connectors arranged in the box shell, light emitting sides of the LED modules being exposed out of the box shell, backlight sides of the LED modules being electrically connected to the PCBA by the connectors, the protection panel being located between the LED modules and the PCBA to package the LED modules inside the box shell.

Wherein, the protection panel is provided with open structures for extending of the connectors therethrough, and the open structures are at least one of through holes, opening slots, hollow outs and opening gaps.

Wherein, the PCBA includes an anti-tamper circuit being electrically connected to the LED modules, and the anti-tamper circuit includes a first connection port for connecting the LED modules in parallel, a first switch unit being electrically connected to the first connection port, a second switch unit being connected to the first switch unit, a second connection port being electrically connected to the second switching unit and configured for connecting an external playback server, and first and signal transmission units both being electrically connected to the first and second switching units, wherein the first signal transmission unit is for transmitting tampering signal, the second signal transmission unit is for transmitting non-tampering signal, and the first signal transmission unit and the second signal transmission unit are selectively conducted.

Wherein, the LED display screen further includes a charging and discharging unit being electrically connected to the first switch unit and the second switch unit, respectively, so as to supply power to the first switch unit and the second switch unit in case of power off.

Wherein, the first switching unit includes a first field-effect transistor and a fifth resistor, a gate of the first field-effect transistor is connected to the first connection port, a drain of the first field-effect transistor is connected to the charging and discharging unit through the fifth resistor, and a source of the first field-effect transistor is grounded; and
the second switching unit includes a second field-effect transistor and a seventh resistor, a gate of the second field-effect transistor is connected to a point of common coupling of the drain of the first field-effect transistor and the fifth resistor, a drain of the second field-effect transistor is connected to the charging and discharging unit through the seventh resistor, and a source of the second field-effect transistor is grounded.

Wherein, the charging and discharging unit includes a charging terminal for connecting an external power source, a first diode, a first resistor, a second resistor, a first capacitor, a second capacitor and a discharging terminal for discharging, a positive pole of the first diode is for connecting the charging terminal, and a negative pole of the first diode is grounded through the second resistor and the second capacitor in sequence; the discharging terminal is grounded through the first resistor and the first capacitor in sequence, and a point of common coupling of the discharging terminal and the first resistor is connected to a point of common coupling of the negative terminal of the first diode and the second resistor.

A screen system includes a display screen and at least one playback server connected to the display screen, wherein the display screen is the foregoing LED display screen.

### BENEFICIAL EFFECTS OF THE INVENTION

### BENEFICIAL EFFECTS

The technical solutions of the present application mainly involves: firstly obtaining the trigger signals of the LED modules of any LED box, then determining whether the trigger signals of the LED modules of any LED box are tampered signals, and finally controlling the LED boxes to stop displaying data when all of the trigger signals of the LED modules of any LED box are tampered signals. In this way, by detecting that all of the trigger signals of the LED modules are tampered signals, it is capable of detecting whether the LED modules work normally, and controlling the LED modules to stop displaying data when any LED modules work abnormally, ensuring the accuracy and security of data display of the LED modules.

### BRIEF DESCRIPTION OF THE DRAWINGS

### DESCRIPTION OF THE DRAWINGS

In order to more effectively demonstrate the technical solutions in the embodiments or prior art of the present application, the accompanying drawings that must be utilized in the description of the embodiments or prior art are briefly described below. It will be apparent that the accompanying drawings in the following description are only some, but not all, embodiments of the present application. For those of ordinary skill in the art, other drawings may be obtained from the provided accompanying drawings without creative labor.
Fig. 1 is a side view of an LED box according to an embodiment of the present application.
Fig. 2 is a schematic view of a protection panel according to an embodiment of the present application.
Fig. 3 is a front view of an LED box according to an embodiment of the present application.
Fig. 4 is a block diagram of an anti-tamper circuit according to an embodiment of the present application.
Fig. 5 is a circuit diagram of an anti-tamper circuit according to an embodiment of the present application.
Fig. 6 is a flowchart of a data display control method for display screen according to an embodiment of the present application.
Fig. 7 is a block diagram of an electronic device according to an embodiment of the present application.

The realization of the purpose, the functional features and advantages of the present application will be further explained in combination with the embodiments and with reference to the accompanying drawings.

### PREFERRED EMBODIMENT OF THE INVENTION

### PREFERRED EMBODIMENT OF THE PRESENT INVENTION

Enter a description for the preferred embodiment of the present invention here.

### EMBODIMENTS OF THE INVENTION

### EMBODIMENTS OF THE PRESENT INVENTION

Technical solutions of embodiments of the present application will be described clearly and completely in combination with the accompanying drawings of embodiments of the present application as follows. Obviously, the described embodiments are only a part of the embodiments of the present application, not all of them. Based on the embodiments of the present application, all other embodiments obtained by those ordinary skilled in the art without creative labor should be fallen within the protection scope of the present application.

It should be noted that the descriptions of "first", "second", etc. in the present application are only for descriptive purposes and cannot be understood as indicating or implying their relative importance or implying the number of indicated technical features. Therefore, features limited to "first" and "second" can explicitly or implicitly include at least one of these features. In addition, the technical solutions of various embodiments may be combined with each other, but must be based on what those ordinary skilled in the art can achieve. When the combination of the technical solutions conflicts or cannot be achieved, it should be considered that the combination of such technical solutions does not exist and is not within the protection scope of the present application.

Different from related technologies that corresponding LED modules need to be removed during maintaining or replacing of the pre maintenance display screen, which results in frequent disconnection or connection of the PCBA, making the LED modules be prone to generate abnormal display problems and finally affecting the pre maintenance display screen, the present application provides an LED display screen and a data display control method therefor, and a screen system, wherein the specific construction or method process thereof please refer to the following embodiments.

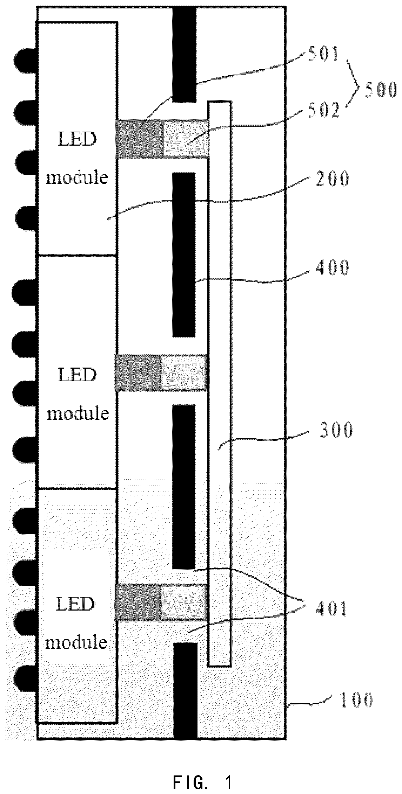

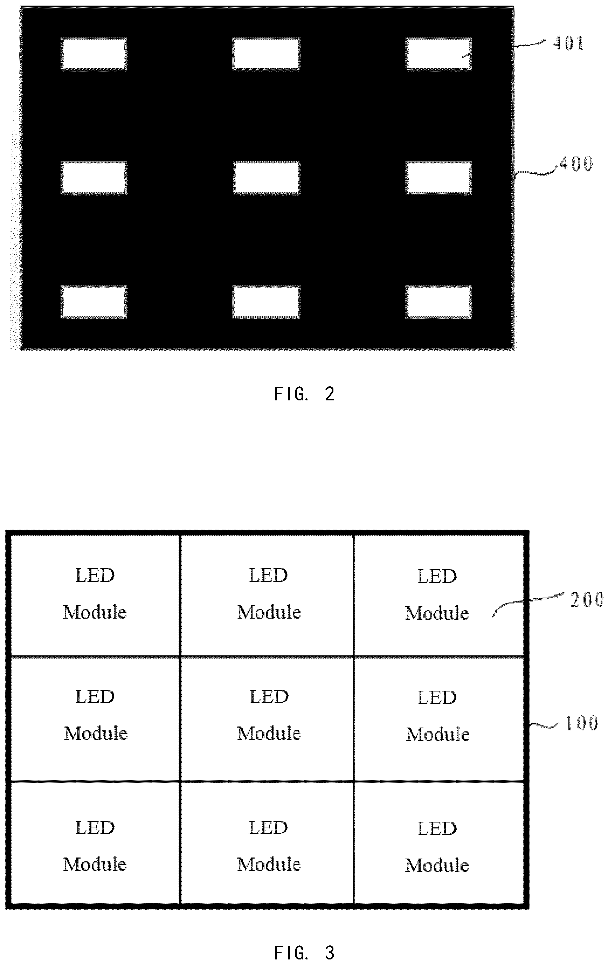

Please refer to Fig. 1 to Fig. 3, wherein Fig. 1 is a side view of an LED box according to an embodiment of the present application, Fig. 2 is a schematic view of a protection panel according to an embodiment of the present application, and Fig. 3 is a front view of an LED box according to an embodiment of the present application. In an embodiment of the present application, the LED display screen includes a plurality of LED boxes, wherein each of the LED boxes includes a plurality of LED modules being capable of emitting triggering signals, and a data display control device for executing the above method. The LED box further includes: a box shell 100 being provided with an accommodating space and a PCBA (Printed Circuit Board Assembly) 300, a protection panel 400 and a plurality of connectors 500 arranged in the box shell 100. Light emitting sides of the LED modules 200 are fully or partially exposed out of the box shell 100, and backlight sides of the LED modules are electrically connected to the PCBA 300 through the connectors 500. The protection panel 400 is located between the LED module and the PCBA 300, so as to package the LED modules 200 inside the box shell 100.

When an interface status between any LED module 200 and the PCBA 300 is disconnected, all of the triggering signals emitted by the LED modules 200 are tampering signals, thereby controlling the LED boxes to stop displaying data.

Specifically, the above LED display screen includes a plurality of LED boxes arranged in rows, columns, or matrices. For a specific construction of the LED box, it mainly includes a box shell 100, a PCBA 300 (also known as the back plate), LED module(s) 200 and a protection panel 400. A number of the LED module(s) 200 may be one or more. The PCBA 300, the LED module(s) 200 and the protection panel 400 are all accommodated in the box shell 100, wherein a light emitting side of the LED module 200 is exposed out of the box shell 100; or, a portion of the LED module 200 is exposed out of the box shell 100 to make the light emitting side of LED module 200 be exposed out of the box shell 100. The above-mentioned light emitting side is a side of an outer surface of the LED module 200 with LED pixels. The backlight side of LED module 200 is set opposite to the light emitting side, and is electrically connected to the PCBA 300 through the connector 500. The protection panel 400, which is used to package the LED modules 200 inside the box shell 100, ensures a reliable connection between the LED modules 200 and the PCBA 300.

Specifically, whether the above protection panel 400 in a packaged state may be detected by whether all of the triggering signals emitted by the LED modules 200 are tampering signals. Specifically, when all of the interface statuses between any LED module 200 and the PCBA 300 are disconnected, the triggering signals emitted by the LED modules 200 are tampering signals, which indicate that the protection panel 400 is in a removed state. At this time, an external playback server controls the LED modules 200 to stop displaying data based on the tampering signals, which can prevent the displayed data from being tampered with and ensure the copyright information of the displayed data. The above-mentioned removed state means that the protection panel 400 is detached from the box shell 100 during maintenance or replacement of internal LED modules 200 of the LED box. When the interface status between any LED module 200 and the PCBA 300 is connected, the triggering signal emitted by the LED module 200 is non-tampering signal, which indicate that the protection panel 400 is in a packaged state. The external playback server controls the LED boxes 200 to continue to display data based on the non-tampering signal, so as to protect the data copyright information of the LED modules 200. The above-mentioned packaged state means that the protection panel 400 packages the LED modules 200 inside the box shell 100, and the LED modules 200 are stably connected to the PCBA 300.

Specifically, for a packaged construction of the protection panel 400, it may partially contact the LED modules 200, thereby limiting positions of the LED modules 200 to ensure stable connection between the LED modules 200 and the PCBA 300. The protection panel 400 may also limit positions of the connectors 500, which in turn lock positions of the LED modules 200, achieving stable connection between the LED modules 200 and the PCBA 300.

The above connector 500 includes a first connector port 501 for electrically connecting the LED module 200 and a second connector port 502 for electrically connecting the PCBA 300. The first connector port 501 is connected to the second connector port 502 to achieve electrical contact between the LED module 200 and the PCBA 300. The first connector port 501 is provided at the backlight side of the LED module 200, and the second connector port 502 is provided at a side of the PCBA 300 adjacent to the backlight side of the LED module 200.

In a specific embodiment, the protection panel 400 is provided with open structures for extending of the connectors 500 therethrough, and the open structures are at least one of through holes, opening slots, hollow outs and opening gaps.

In this embodiment, the protection panel 400 includes open structures 401 for extending of the connectors 500 therethrough, which may be at least one of through holes, opening slots, hollow outs and opening gaps. Specifically, the protection panel 400 is provided with open structures at positions thereof corresponding to each of the LED modules 200, so as to allow the connectors 500 to pass through the protection panel 400 smoothly.

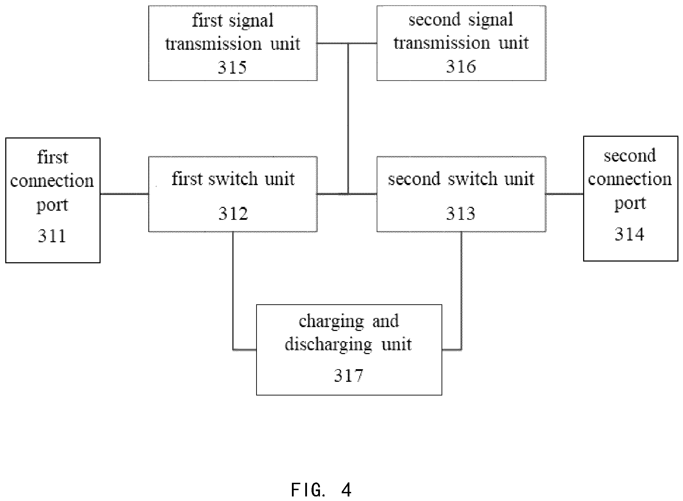

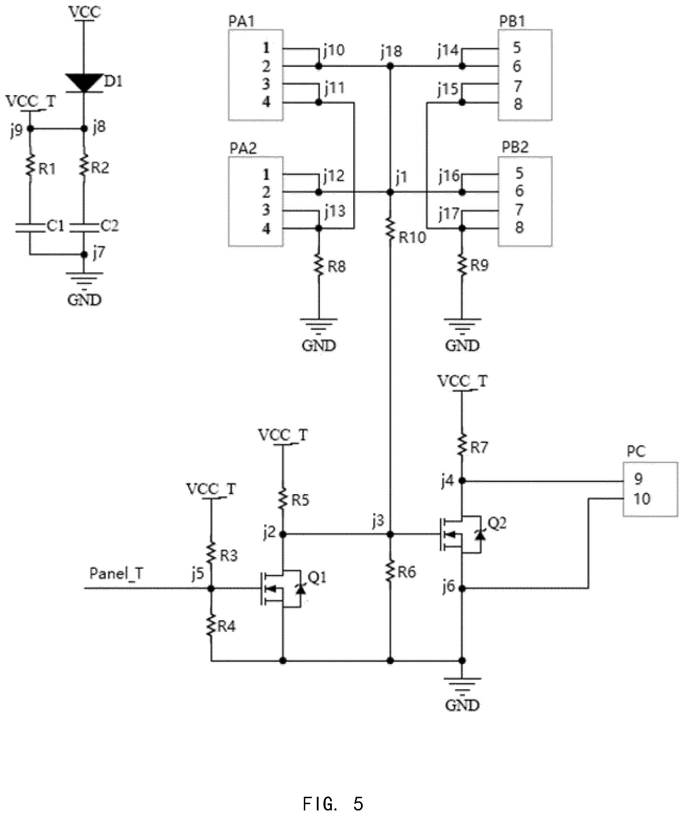

Please refer to Fig. 4 and Fig. 5, wherein Fig. 4 is a block diagram of an anti-tamper circuit according to an embodiment of the present application, and Fig. 5 is a circuit diagram of an anti-tamper circuit according to an embodiment of the present application. In a specific embodiment, the PCBA 300 includes an anti-tamper circuit being electrically connected to the LED modules 200. The anti-tamper circuit includes: a first connection port 311 for connecting the LED modules 200 in parallel, a first switch unit 312 being electrically connected to the first connection port 311, a second switch unit 313 being connected to the first switch unit 312, a second connection port 314 being electrically connected to the second switching unit 313 and configured for connecting an external playback server, and first and signal transmission units 315 both being electrically connected to the first switching unit 312 and the second switching unit 313, wherein the first signal transmission unit 315 is for transmitting tampering signal, the second signal transmission unit 316 is for transmitting non-tampering signal, and the first signal transmission unit 315 and the second signal transmission unit 316 are selectively conducted.

In this embodiment, the first connection port 311 is used to connect the LED module 200. The interface status between the LED module 200 and the PCBA 300 may be detected. When all of the interface statuses between any LED module 200 and the PCBA 300 are disconnected, all of the first connection ports 311 are high level. When the interface status between any LED module 200 and the PCBA 300 is connected, the first connection port 311 is low level.

Specifically, when the first connection port 311 is in a state of low level, the first switch unit 312 is in a closed state and the second switch unit 313 is in an open state. At this time, a non-tampering signal will be triggered. The triggered non-tampering signal will be transmitted to the second connection port 314 through the first signal transmission unit 315 or the second signal transmission unit 316, wherein the second connection port 314 will be in a conductive state at this time. When the playback server receives the non-tampering signal transmitted by the second connection port 314, it drives its normally closed port to a closed state, that is, the playback server continues to operate normally. When all of the first connection ports 311 are in a state of high level, the first switch unit 312 is in an open state and the second switch unit 313 is in a closed state. At this time, a tampering signal will be triggered. The triggered tampering signal will be transmitted to the second connection port 314 through the first signal transmission unit 315 or the second signal transmission unit 316, wherein the second connection port 314 will be in a state of high resistance at this time. When the playback server receives the tampering signal transmitted by the second connection port 314, it drives its normally closed port to an open state, that is, the playback server stops working.

The above first signal transmission unit 315 and second signal transmission unit 316 each include two transmission terminals PA, PB connected in series. One pin of the transmission terminal PA is connected to one pin of the transmission terminal PB; a point of common coupling of two transmission terminals PA, PB is connected to a point of common coupling of the first switch unit 312 and the second switch unit 313; and another pins of two transmission terminals PA, PB are connected, and are grounded through resistors R8 and R9.

In a specific embodiment, the LED display screen further includes a charging and discharging unit 317 which is electrically connected to the first switching unit 312 and the second switching unit 313, respectively, so as to provide power to the first switching unit 312 and the second switching unit 313 in case of power off.

Specifically, the above charging and discharging unit 317 may further be connected to an external power source. When the charging and discharging unit 317 is in a charging state, the external power source charges the charging and discharging unit 317 until it is fully charged. When the charging and discharging unit 317 is in a discharging state, it supplies power to the first switching unit 312 and the second switching unit 313, thereby providing power to the first switching unit 312 and the second switching unit 313 if the external power source is cut off.

Specifically, the first switching unit 312 includes a first field-effect transistor Q1 and a fifth resistor R5. A gate of the first field-effect transistor Q1 is connected to the first connection port 311, a drain of the first field-effect transistor Q1 is connected to the charging and discharging unit 317 through the fifth resistor R5, and a source of the first field-effect transistor Q1 is grounded. Correspondingly, the second switching unit 313 includes a second field-effect transistor Q2 and a seventh resistor R7. A gate of the second field-effect transistor Q2 is connected to a point of common coupling of the drain of the first field-effect transistor Q1 and the fifth resistor R5, a drain of the second field-effect transistor Q2 is connected to the charging and discharging unit 317 through the seventh resistor R7, and a source of the second field-effect transistor Q2 is grounded.

When the first connection port 311 is in a state of low level, the first field-effect transistor Q1 is in a cut-off state, and the second field-effect transistor Q2 is in a conductive state. At this time, when the playback server receives the non-tampering signal transmitted by the second connection port 314, it drives its normally closed port to a closed state, that is, the playback server continues to operate normally. When the first connection port 311 is in a state of high level, the first field-effect transistor Q1 is in a conductive state, and the second field-effect transistor Q2 is in a cut-off state. At this time, the playback server receives the tampering signal transmitted by the second connection port 314 and drives its normally closed port to be in an open state, that is, the playback server stops working.

Specifically, there are nine LED modules 200 in this solution, namely M1, M2, M3, M4, M5, M6, M7, M8, and M9, respectively. When all of the nine LED modules 200 are disconnected from the gate of the first field-effect transistor Q1, the electrical levels between the nine LED modules 200 and the gate of the first field-effect transistor Q1 are high levels. At this time, a tampering signal will be triggered. The triggered tampering signal will be transmitted to the second connection port 314 through the first signal transmission unit 315 or the second signal transmission unit 316, wherein the second connection port 314 will be in a in a conductive state at this time. When the playback server receives the tampering signal at the second connection port 314, it will drive its internal normally closed port to open, that is, the digital movie playback server will stop working. When some of the nine LED modules 200 are connected to the gate of the first field-effect transistor Q1, the electrical levels between the some of the nine LED modules 200 and the gate of the first field-effect transistor Q1 are low levels, and the electrical levels between the remaining of the nine LED modules 200 and the gate of the first field-effect transistor Q1 are low levels. At this time, a non-tampering signal will be triggered. The triggered non-tampering signal will be transmitted to the second connection port 314 through the first signal transmission unit 315 or the second signal transmission unit 316, wherein the second connection port 314 will be in a in a conductive state at this time. When the playback server receives the non-tampering signal at the second connection port 314, it will drive its internal normally closed port to close, that is, the playback server is working normally. When all of the nine LED modules 200 are connected to the gate of the first field-effect transistor Q1, the electrical levels between the nine LED modules 200 and the gate of the first field-effect transistor Q1 are all low levels. At this time, a non-tampering signal will be triggered. The triggered non-tampering signal will be transmitted to the second connection port 314 through the first signal transmission unit 315 or the second signal transmission unit 316, wherein the second connection port 314 will be in a in a conductive state at this time. When the playback server receives the non-tampering signal at the second connection port 314, it will drive its internal normally closed port to close, that is, the digital movie playback server continues to operate normally.

For understanding this working process clearly, a working logic diagram below may be referred. In the diagram, "0" indicates that the LED module 200 is connected to the gate of the first FET Q1, "1" indicates that the LED module 200 is disconnected from the gate of the first FET Q1, and "X" indicates that a relationship between the LED module 200 and the gate of the first FET Q1 is either connected or disconnected.

### Table 1

**Table 1**

| M1 | M2 | M3 | M4 | M5 | M6 | M7 | M8 | M9 | PC |
|---|---|---|---|---|---|---|---|---|---|
| 0 | × | × | × | × | × | × | × | × | Normal |
| × | 0 | × | × | × | × | × | × | × | Normal |
| × | × | 0 | × | × | × | × | × | × | Normal |
| × | × | × | 0 | × | × | × | × | × | Normal |
| × | × | × | × | 0 | × | × | × | × | Normal |
| × | × | × | × | × | 0 | × | × | × | Normal |
| × | × | × | × | × | × | 0 | × | × | Normal |
| × | × | × | × | × | × | × | 0 | × | Normal |
| × | × | × | × | × | × | × | × | 0 | Normal |
| 1 | 1 | 1 | 1 | 1 | 1 | 1 | 1 | 1 | Stop |

During this working process, if the external power source continues to supply power, the charging and discharging unit 317 is in a charging state until it is fully charged; and if the external power source is cut off, the charging and discharging unit 317 is in a discharging state, which can supply power to the above anti-tamper circuit, so as to ensure normal operation of the anti-tamper circuit. Since the playback server can use the internal power supply to ensure its normal operation and the anti-tamper circuit has the charging and discharging unit 317 for anti power off, both the playback server and the anti-tamper circuit can operate normally during power off, so as to ensure the reliability of digital copyright protection.

Furthermore, the first switching unit 312 further includes a third resistor R3 and a fourth resistor R4 connected in serious. One end of the third resistor R3 is connected to the charging and discharging unit 317, a point of common coupling of the third resistor R3 and the fourth resistor R4 is connected to the gate of the first field-effect transistor Q1, and another end of the fourth resistor R4 is grounded. The second switching unit 313 further includes a sixth resistor R6 and a tenth resistor R10 connected in series. One end of the sixth resistor R6 is connected to a point of common coupling of the first signal transmission unit 315 and the second signal transmission unit 316, a point of common coupling of the sixth resistor R6 and the tenth resistor R10 is connected to the gate of the second field-effect transistor Q2, and another end of the sixth resistor R6 is grounded.

Furthermore, the charging and discharging unit 317 includes a charging terminal for connecting an external power source VCC, a first diode D1, a first resistor R1, a second resistor R2, a first capacitor C1, a second capacitor C2 and a discharging terminal VCC_T for discharging. A positive pole of the first diode D1 is used to connect the charging terminal, and a negative pole of the first diode D1 is grounded through the second resistor R2 and the second capacitor C2 in sequence. The discharging terminal VCC_T is grounded through the first resistor R1 and the first capacitor C1 in sequence. A point of common coupling of the discharging terminal VCC_T and the first resistor R1 is connected to a point of common coupling of the negative pole of the first diode D1 and the second resistor R2. In the charging state, the power of the external power source VCC is introduced into the first capacitor C1 and the second capacitor C2 through the charging terminal, and the discharging terminal VCC_T is not in a power supply state. In the discharging state, the first capacitor C1 and the second capacitor C2 supplies power to the outside through the discharging terminal VCC_T, and the charging terminal is in a disconnected state at this time.

In an embodiment of the present application, the LED display screen generally includes a circuit backboard and a HUB board. A board with the above anti-tamper circuit may be either a circuit backboard or a HUB board. The above anti-tamper circuit is integrated into the HUB board and there may be a plurality of HUB boards. Each of the HUB boards corresponds to a plurality of LED modules 200. Any one of the HUB boards may transmit tampering signal/non-tampering signal to adjacent HUB boards through the first signal transmission unit 315 or the second signal transmission unit 316 of the anti-tamper circuit, wherein adjacent HUB boards refer to other HUB boards located in the upper, lower, left, and right directions of this HUB board centered around this HUB board. Finally, the tampering/non-tampering signal will reach the second connection port 314, causing the playback server to switch between normal and stopped working states. The first signal transmission unit 315 may be used for signal transmission with HUB boards located in the upper and lower directions, and the second signal transmission unit 316 may be used for signal transmission with HUB boards located in the left and right directions. It can be understood that the first signal transmission unit 315 may also be used for signal transmission with HUB boards located in the left and right directions, and the second signal transmission unit 316 may also be used for signal transmission with HUB boards located in the up and down directions.

In an embodiment of the present application, the screen system includes a display screen and at least one playback server connected to the display screen, wherein the display screen is the LED display screen described above. A specific construction of the LED display screen may refer to each one of the above embodiments, which will not be repeated here. Due to the application of the above LED display screen in this screen system, it has all advantages and effects of the LED display screen. Specifically, the screen system may be a movie screen, LCD TV wall, etc., configured for playing information such as movies, TV dramas, advertisements, etc.

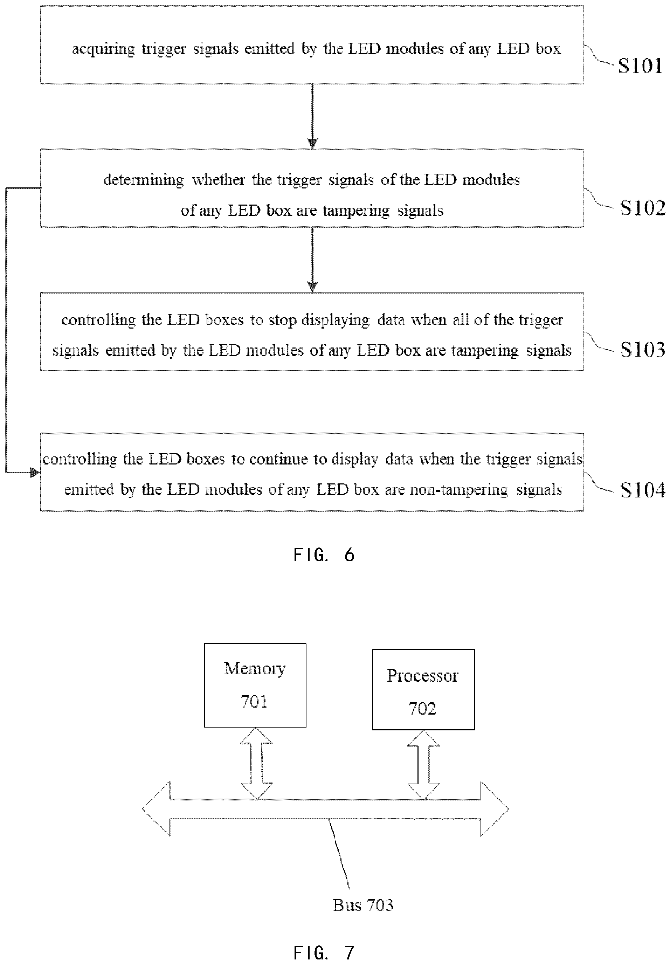

Please refer to Fig. 6, which is a flowchart of a data display control method for display screen according to an embodiment of the present application. In an embodiment of the present application, the data display control method for display screen is applied to an LED display screen. The display screen includes a plurality of LED boxes, and each of the LED boxes includes a plurality of LED modules that can emit triggering signals. The data display control method for display screen includes the following steps:
S101, acquiring triggering signals emitted by the LED modules of any LED box.

Specifically, when the LED display screen is working, all of the LED boxes work simultaneously. That is, all of the LED modules of the LED boxes work simultaneously. The LED modules emit triggering signals when they are working. The triggering signal may be used to detect the status of the LED module, so as to determine whether the current status of the LED module is normal.

S102, determining whether the triggered signals of the LED modules of any LED box are tampering signals.

Specifically, the triggering signals emitted by the LED modules are divided into two types: one is tampering signal and the other is non-tampering signal. When the triggering signal emitted by each of the LED modules is tampering signal, all of the LED modules of the corresponding LED box are in an abnormal display state. When the triggering signal emitted by any LED module is non-tampering signal, some LED module(s) of the corresponding LED box is/are in an abnormal display state, or so, the LED modules are in a normal display state.

S103, controlling the LED boxes to stop displaying data when all of the triggering signals emitted by the LED modules of any LED box are tampering signals.

Specifically, when all of the triggering signals emitted by the LED modules of any LED box are tampering signals, it means that the protection panel of the LED box is in a removed state. At this time, the display data of the LED modules of the LED box is easily to be tampered with, and the playback server controls the LED boxes to stop displaying data. It may be understood that when one of the LED boxes cannot display, the playback server controls the whole LED display screen to stop working.

S104, controlling the LED boxes to continue to display data when the triggering signal(s) emitted by the LED modules of any LED box is/are non-tampering signal. Specifically, when the triggering signal(s) emitted by the LED modules of any LED box is/are non-tampering signal(s), it means that the protection panel of the LED box is in a packaged state. At this time, the display data of the LED modules of the LED box is not easily to be tampered with, and the playback server controls the LED boxes to continue to display data.

Furthermore, the LED box further includes a PCBA being electrically connected to the plurality of LED modules, respectively. The step of determining whether all of the triggering signals of the LED modules of any LED box are tampering signals, including:
determining an interface status between any LED module and the PCBA;
generating a triggering signal and determining that this triggering signal is tampering signal when all of the interface statuses between any LED module and the PCBA are disconnected;
generating a triggering signal and determining that this triggering signal is non-tampering signal when the interface status between any LED module and the PCBA is connected.

Specifically, when all of the interface statuses between any LED module and the PCBA are disconnected, a triggering signal is generated, which is recognized as a tampering signal; and when the interface status between any LED module and the PCBA is connected, a triggering signal is generated, which is recognized as a non-tampering signal.

Furthermore, the PCBA includes an anti-tamper circuit. After the step of determining the interface status between any LED module and the PCBA, the method includes:
generating a triggering signal and determining that this triggering signal is tampering signal when all of the interface statuses between any LED module and the PCBA are high level;
generating a triggering signal and determining that this triggering signal is non-tampering signal when the interface status between any LED module and the PCBA is low level, and controlling the LED boxes to continue displaying data based on the non-tampering signal.

Specifically, when all of the interface statuses between any LED module and the PCBA are high level, a first triggering signal is generated based on that all interface statuses are high level and determined to be a tampering signal; when the interface status between any LED module and the PCBA is low level, a second triggering signal is generated based on that any interface status is low level and determined to be a tampering signal, which simplifies the identification of the triggering signal through high and low levels.

Please refer to Fig. 7, which is a block diagram of an electronic device according to an embodiment of the present application. The electronic device may be used to implement the data display control method for display screen in each of the foregoing embodiments. As shown in Fig. 7, the electronic device mainly includes a memory 701, a processor 702, a bus 703 and a computer program which is stored on the memory 701 and executable by the processor 702. The memory 701 and the processor 702 are connected through the bus 703. When the processor 702 executes the computer program, the data display control method for display screen of each of the foregoing embodiments is implemented, wherein there may be one or more processor(s).

The memory 701 may be high-speed random access memory (RAM) or non volatile memory, such as disk storage. The memory 701 is used to store executable program code thereon, and the processor 702 is electrically coupled to the memory 701.

Furthermore, an embodiment of the present application further provides a readable storage medium, which may be set in the electronic device of each of the foregoing embodiments, or may be the memory of the foregoing embodiment as shown in FIG. 7.

The computer program is stored on the readable storage medium, and is executed by the processor to realize the data display control method for display screen of each of the foregoing embodiments. Further, the computer-storable storage medium may further be a U disk, a mobile hard disk, a read-only memory (ROM), a random-access memory (RAM), a magnetic disk or an optical disk, and other various media that may store the program code.

For the several embodiments provided by the present application, it should be understood that the disclosed devices and methods may be implemented in other ways. For example, the device of the above embodiments are only schematic; for example, the division of modules is only a logical functional division, and there may be other division methods in actual implementation, such as multiple modules or components may be combined or integrated into another system, or some features may be ignored or not executed. In addition, coupling or direct coupling or communication connection to each other as displayed or discussed may be indirect coupling or communication connection through some interfaces, devices or modules, which can be electrical, mechanical or other forms.

The modules described as separate components may be or may not be physically separated; and the components displayed as modules may be or may not be physical modules, which can be located in one place or distributed across multiple network modules. Some or all modules may be selected according to actual needs to achieve the purpose of this embodiment.

In addition, the functional modules in various embodiments of the present application may be integrated into a single processing module, or may physically exist separately, or two or more of those may be integrated into one module. The integrated modules mentioned above may be implemented in both hardware and software functional modules.

If an integrated module is implemented in the form of a software functional module and sold or used as an independent product, it can be stored on a computer readable storage medium. Based on this understanding, the technical solutions of the present application may essentially or partially contribute to the relevant technology, or all or part of the technical solutions may be reflected in the form of a software product, which is stored in a readable storage medium, including a plurality of instructions to enable a computer device (which may be a personal computer, server, or network device, etc.) to execute all or part of the steps of the various embodiments of the method of the present application. The above readable storage media include various media that can store program code, such as USB flash drives, mobile hard drives, ROMs, RAM, magnetic disks, optical disks and etc.

It should be noted that for the convenience of description, each of the aforementioned embodiments of the method is expressed as a series of action combinations. However, those skilled in the art should be aware that the present application is not limited by the described action sequence, as according to the present application, some steps may be performed in other sequences or simultaneously. Secondly, those skilled in the art should also be aware that the embodiments described in the specification are preferred embodiments, and the actions and modules involved may be unnecessary for the present application.

In the above embodiments, the descriptions of each embodiment have their own emphasis. For the parts that are not detailed in one embodiment, please refer to the relevant descriptions of other embodiments.

The above is only preferred embodiments of the present invention, which is not intended to limit the present application. Any equivalent substitutions made without departing from the spirit and principles of the present application and the accompanying drawings, or direct/indirect applications in other related technical fields, should be within the scope of protection of the present application.

### INDUSTRIAL APPLICABILITY

Enter a description for the industrial applicability here.

### SEQUENCE LISTING FREE CONTENT

Enter a description for the sequence listing free content here.

## Claims

1. A data display control method for display screen, wherein the display screen comprises a plurality of LED boxes, and each of the plurality of LED boxes comprises a plurality of LED modules capable of emitting triggering signals, comprising:
acquiring the triggering signals emitted by the LED modules of any LED box;
determining whether the triggering signals of the LED modules of any LED box are tampering signals;
controlling the LED boxes to stop displaying data when all of the triggering signals emitted by the LED modules of any LED box are tampering signals.

2. The data display control method for display screen according to claim 1, wherein the LED box further comprises a PCBA being electrically connected to the plurality of LED modules, respectively, and the step of determining whether all of the triggering signals of the LED modules of any LED box are tampering signals comprises:
determining an interface status between any LED module and the PCBA;
generating a triggering signal and determining that this triggering signal is tampering signal when all of the interface statuses between any LED module and the PCBA are disconnected;
generating a triggering signal and determining that this triggering signal is non-tampering signal when the interface status between any LED module and the PCBA is connected.

3. The data display control method for display screen according to claim 2, wherein the PCBA comprises an anti-tamper circuit, and after the step of determining the interface status between any LED module and the PCBA, the method comprises:
generating a triggering signal and determining that this triggering signal is tampering signal when all of the interface statuses between any LED module and the PCBA are high level;
generating a triggering signal and determining that this triggering signal is non-tampering signal when the interface status between any LED module and the PCBA is low level, and controlling the LED boxes to continue displaying data based on the non-tampering signal.

4. An LED display screen comprising a plurality of LED boxes, each of the LED boxes comprising a plurality of LED modules capable of emitting triggering signals and a data display control device for executing the method according to any one of claims 1-3.

5. The LED display screen according to claim 4, wherein the LED box further comprises a box shell being provided with an accommodating space and a PCBA, a protection panel and a plurality of connectors arranged in the box shell, light emitting sides of the LED modules being exposed out of the box shell, backlight sides of the LED modules being electrically connected to the PCBA by the connectors, the protection panel being located between the LED modules and the PCBA to package the LED modules inside the box shell.

6. The LED display screen according to claim 5, wherein the protection panel is provided with open structures for extending of the connectors therethrough, and the open structures are at least one of through holes, opening slots, hollow outs and opening gaps.

7. The LED display screen according to claim 5, wherein the PCBA comprises an anti-tamper circuit being electrically connected to the LED modules, and the anti-tamper circuit comprises a first connection port for connecting the LED modules in parallel, a first switch unit being electrically connected to the first connection port, a second switch unit being connected to the first switch unit, a second connection port being electrically connected to the second switching unit and configured for connecting an external playback server, and first and signal transmission units both being electrically connected to the first and second switching units, wherein the first signal transmission unit is for transmitting tampering signal, the second signal transmission unit is for transmitting non-tampering signal, and the first signal transmission unit and the second signal transmission unit are selectively conducted.

8. The LED display screen according to claim 7, further comprising a charging and discharging unit being electrically connected to the first switch unit and the second switch unit, respectively, so as to supply power to the first switch unit and the second switch unit in case of power off.

9. The LED display screen according to claim 8, wherein the first switching unit comprises a first field-effect transistor and a fifth resistor, a gate of the first field-effect transistor is connected to the first connection port, a drain of the first field-effect transistor is connected to the charging and discharging unit through the fifth resistor, and a source of the first field-effect transistor is grounded; and
the second switching unit comprises a second field-effect transistor and a seventh resistor, a gate of the second field-effect transistor is connected to a point of common coupling of the drain of the first field-effect transistor and the fifth resistor, a drain of the second field-effect transistor is connected to the charging and discharging unit through the seventh resistor, and a source of the second field-effect transistor is grounded.

10. The LED display screen according to claim 9, wherein the charging and discharging unit comprises a charging terminal for connecting an external power source, a first diode, a first resistor, a second resistor, a first capacitor, a second capacitor and a discharging terminal for discharging, a positive pole of the first diode is for connecting the charging terminal, and a negative pole of the first diode is grounded through the second resistor and the second capacitor in sequence; the discharging terminal is grounded through the first resistor and the first capacitor in sequence, and a point of common coupling of the discharging terminal and the first resistor is connected to a point of common coupling of the negative terminal of the first diode and the second resistor.

11. A screen system comprising a display screen and at least one playback server connected to the display screen, wherein the display screen is the LED display screen according to any one of claims 4-10.
